# EUROPEAN PATENT SPECIFICATION

(11) **EP 3 121 913 B1**
(45) Date of publication and mention of the grant of the patent: **02.10.2019**
(21) Application number: 15765283.5
(22) Date of filing: 13.02.2015
(51) Int. Cl.: H01S 5/042, H01S 5/062, H01S 5/40

(54) **LASER CONTROL CIRCUIT, CONTROL METHOD AND LASER INK LINE DEVICE HAVING LASER CONTROL CIRCUIT**
LASERSTEUERUNGSSCHALTUNG, STEUERUNGSVERFAHREN UND LASERTINTENVORRICHTUNG MIT LASERSTEUERUNGSSCHALTUNG
CIRCUIT DE COMMANDE DE LASER, PROCÉDÉ DE COMMANDE ET DISPOSITIF DE LIGNE D'ENCRE LASER AYANT UN CIRCUIT DE COMMANDE DE LASER

(30) Priority: 20.03.2014 CN 201410106424
(43) Date of publication of application: 25.01.2017
(73) Proprietor: Changzhou Huada Kejie Opto-Electro Instrument CO., LTD., Jiangsu 213023 (CN)
(72) Inventor: NIU, Qing, Changzhou Jiangsu 213023 (CN); FU, Junjie, Changzhou Jiangsu 213023 (CN); ZHANG, Ou, Changzhou, Jiangsu 213023 (CN)
(74) Representative: Lambsdorff & Lange Patentanwälte Partnerschaft mbB
(86) International application number: PCT/CN2015/072970
(87) International publication number: WO 2015/139544

(56) References cited:
- CN-A- 102 595 681
- CN-A- 103 887 706
- CN-U- 202 797 600
- CN-U- 203 826 766
- JP-A- 2005 121 608
- US-A- 5 512 932
- US-A1- 2009 310 978

## Description

### TECHNICAL FIELD

The present invention relates to a laser device, and specifically to a laser control circuit, a control method and a laser ink line device with laser control circuit.

### BACKGROUND ART

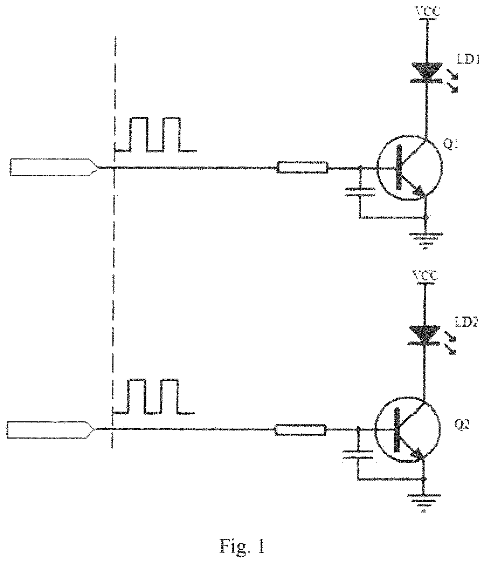

The laser ink line device is a regular device in the field of laser devices. As for the control manner for the laser tubes in a laser ink line device, as shown in Fig. 1, it is regularly applied to provide with a very simple control circuit in which a control signal generator is configured for each laser tube and directly sends square waves of high-low level to control the on-off of laser tubes.

As the control circuit sends the same control signals to all laser tubes in the above manner, the open/close state of all laser tubes are the same and the function is single which cannot satisfy with the user's needs. Moreover, even more important, the open/close of laser tubes in the same time will cause the peak interference, that is, when the current is larger, the frequency of the peak interference will improve, causing damage for the laser tubes. In addition, as Alkaline dry battery and NI-MH battery provide with the power source for the laser ink line device, a non-continuous large current will discharge, which will shorten the discharge time of batteries.

US2009/0310978 A1 discloses different laser diodes which are controlled in an alternate manner in order to reduce power consumption using a single pulse generator and logic gates. US 5512932 A discloses alternate power control of two laser diodes.

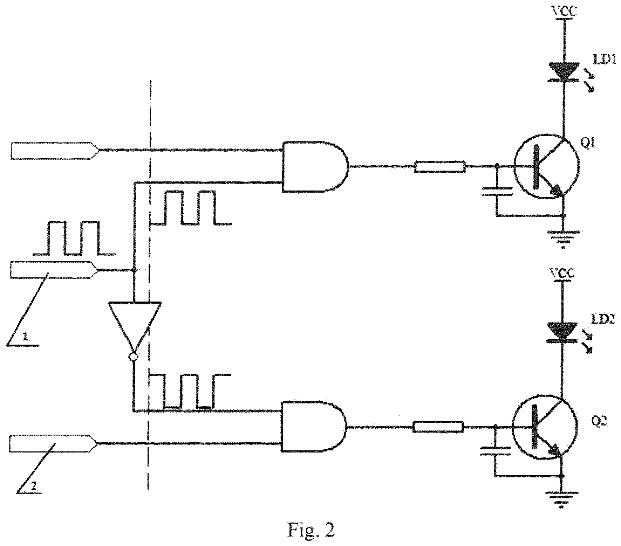

In the following the term "laser tube" is used to refer to a "laser diode" (see for example Fig. 2 and corresponding discussion). In order to overcome the aforementioned limitation, solve the problem in the prior art and improve the user experience for the laser ink line device, the present invention provides a new laser control circuit for controlling laser tubes more flexibly, reducing the working current for laser tubes and avoiding the peak interference.

### SUMMARY OF THE INVENTION

The objective of the present invention is to provide a laser control circuit so as to provide continuously and smoothly working current to the laser ink line device with the laser control circuit and reduce the damages caused by the peak interference. The object of the invention is fulfilled by a device as defined in independent claim 1. Preferred embodiments are defined in the dependent claims.

The present invention provides a laser control circuit, comprising at least two laser tubes and a control unit controlling the at least two laser tubes respectively; the control unit sends control signals to the at least two laser tubes to control startup/shutdown thereof; the control unit comprises: a main pulse signal generator and a logic control unit; the main pulse signal generator, the logic control unit and the at least two laser tubes are connected successively; the main pulse signal generator sends control signals to the logic control unit; and the logic control unit classifies the control signals into different types of control signals and sends to the at least two laser tubes, causing the at least two laser tubes to present different working conditions.

The logic control unit comprises a NOT gate; the at least two laser tubes include a first laser tube group and a second laser tube group; an output end of the main pulse signal generator is connected with an input end of the NOT gate and the first laser tube group so as to send a main control signal to the input end of the NOT gate and the first laser tube group; an output end of the NOT gate connected with the second laser tube group is configured for having the main control signal be inverted and having the first and second laser group startup/shutdown alternately.

The control unit further comprises: at least two secondary pulse signal generators and at least two AND gates; each secondary pulse signal generator is connected with a first input end of each AND gate and sends a secondary pulse signal to the AND gate; a second input end of the AND gate is connected with the main pulse signal generator, while an output end of the AND gate is connected with each laser tube of the first laser tube group; the second input end of the AND gate is connected with the output end of NOT gate so that the main pulse signal generator and the secondary pulse signal generator control the startup/shutdown of each laser tube, while an output end of the AND gate is connected with each laser tube of the second laser tube group.

Preferably, the main pulse signal generator and the secondary pulse signal generator are a Single Chip Microcomputer.

Preferably, the main control signal and the secondary control signal have a frequency of 10 kHz.

Preferably, the first and second laser tube group include one laser tube respectively.

The present invention further provides a laser ink line device with the laser control circuit.

In the above technical solution, the startup/shutdown state of the first and second laser tube group may be alternately, and the working current is controlled above the maximum working current of the laser tube group instead of the superposition in the prior art, so as to reduce the working current, avoid the peak interference and prevent the laser tubes from being damaged. Additionally, a continuously and smoothly current is provided when the laser ink line device works, which may extend discharge time of Alkaline dry battery and NI-MH battery.

### BRIEF DESCRIPTION OF THE DRAWINGS

Figure 1 shows the control circuit in the prior art; and
Figure 2 shows the control circuit in a preferred embodiment of the present invention.
   1 main pulse signal generator;
   2 secondary pulse signal generator.

### DETAILED DESCRIPTION OF THE EMBODIMENTS

The advantages of the present invention will be detailed and described in reference to the drawings and the embodiments as follows.

As shown in Fig 2, in a preferred embodiment of the present invention, a laser control circuit comprises at least two laser tubes and a control unit configured for controlling the at least two laser tubes, so that the control unit may control the startup/shutdown state of the laser tubes through sending control signals to each laser tube. In the present invention, in order to solve the above-mentioned problem, the at least two laser tubes are classified into two groups, i.e., a first laser tube and a second laser tube. It is pointed out that the method of classification is not limited, and the user, depending on the actual working requirements, may classify the laser to be a first group and a second group on basis of different displaying status as needed, for example, may define one laser tube as a first laser group and define another one as a second laser group, or classify all laser tubes into the corresponding two. The classification is flexible.

Furthermore, the control unit further comprises a main pulse signal generator 1, as same as other controllers contained in the control unit, the main pulse signal generator 1 is configured for sending a control signal to control the status of laser tubes. Moreover, the control unit further comprises a logical control unit provided among the main pulse signal generator 1, the first and second laser groups to classify the control signals from the main pulse signals into two for being sent to the first and second laser groups separately. After receiving the different control signals, the first laser group will present a startup/shutdown state while the second laser group presents a shutdown/startup state which is contrary to that of the first laser group.

In a preferred embodiment, the logic control unit is a NOT gate which is connected with the main pulse signal generator 1, the first and second laser group in a manner of: an output end of the main pulse signal generator 1 is connected with an input end of the NOT gate and the first laser tube, so that the first laser may directly receive the control signals from the main pulse signal generator 1 and determine if startup or shutdown according to the control signals as received; an output end of the NOT gate is connected with the second laser tube group, so that control signals from the main pulse signal generator 1 may be sent to the second laser tube group through the NOT gate, in this circumstances, the control signals received from the second laser group are always inverted to that received from the first laser group, i.e., the working state of the first and second laser group is always contrary to each other.

In examples usefull for the understanding of the invention the logic control unit may be a NAND gate (not shown), i.e., both two output ends of the main pulse signal generator 1 are connected with an input end of the NAND gate. In addition, one of the output ends of the main pulse signal generator I is directly connected with the first laser group so that the control signals received by the first laser group are the control signals sent from the main pulse signal generator 1. If the output of the control signal through the NAND gate is a low level while its input is a high level, the first laser group will start and the second laser group will close; if the output is a high level while the input is a low level, the second laser group will startup and the first laser group will shutdown, which causes the two laser groups being inverted.

Compared with above-mentioned logical control unit which is a NOT gate, the control circuit for a NAND gate is more complicated and requires much more for the circuit, therefore, a NOT gate would be more simply and practical.

In order to have each laser tube controlled by the external control device, more preferably, the control unit further comprises at least two secondary pulse signal generators 2 and at least two AND gates. The secondary pulse signal generators are corresponding to the main pulse signal generators, specially, one secondary pulse signal generator and one AND gate are corresponding to each laser tube with the following connecting method: each secondary pulse signal generator 2 is connected with a first input end of the AND gate for sending control signals to the AND gate; the connection for a second output of the NOT gate depends on the classification of laser tubes, specially, one second input end of the AND gate connected with the first laser tube group is further connected with the main pulse signal generator 1, while the other second input end of the AND gate connected with the second laser tube group is connected with the output end of the NOT gate, i.e., the inputs of both two input ends of the AND gate connected with the first laser tube group are secondary controls signals and main control signals respectively, instead, the inputs of both two input ends of the AND gate connected with the second laser tube group are secondary control signals and inverted main control signals respectively. In the meantime, output ends of the AND gate are connected with each laser tube.

In this circumstance, the laser tubes can determine if startup/shutdown on the basis of if the main control signals are inverted or not only when the input of the secondary pulse signal is a high level. When the external control device is under control and the input of the secondary pulse signal is a low level, the output of the AND gate must be a low level and the laser tubes will not be startup, whenever the input of the second end of the AND gate is a high or low level. Therefore, users may control the startup/shutdown of laser tubers by handing an external control device.

In a preferred embodiment, the main and secondary pulse signal generator 1, 2 is a Single Chip Microcomputer ("SCM") having the function of adjusting control signals. Compared with a simple timer and other time counters, it may improve the duty ratio of control signals.

The main control signal and the secondary control signal may be a control signal with frequency of 10 kHz. Users may select a different frequency, e.g., 7.8125 kHz, 5 kHz etc. The 10 kHz may improve the anti-interference performance against sunshine when a high laser detects, although the selection of the frequency is determined by the needs of a laser detector. In all above-mentioned preferred embodiments, quantity of laser tubers included by first and second laser tube group may be one. As more laser tubers will require more working current superposition, which cause the peak pulse interference when open or close the power source, quantity of laser tubers shall be two, one for the fist laser group and the other one for the second laser group, so that the working current will be the maximum current of the two laser tubes. Specially, as the following table shows, the first laser tube contained in the first laser group is defined as I₁ and the first laser tube contained in the first laser group is defined as I₂.

| | | | | |
|---|---|---|---|---|
| Secondary control signal | 1 | | 0 | |
| Working current of the prior art | I₁+I₂ | | 0 | |
| Main Control Signal | 1 | 0 | 1 | 0 |
| Working current of the present invention | I₁ | I₂ | 0 | 0 |

In the prior art, the maximum current of a laser ink line device is the sum of two laser tubes, i.e., I₁+I₂. In the present application, since the two laser tubes open alternatively, the maximum current will be I₁ when the first laser tube works, and the maximum current will be I₂ when the second laser tube works. Compared with the prior art, the maximum current will reduce 50% than that of the prior art if the working current of the first laser tube I₁ is equal to that of the second laser tube I₂, the working current will be more smoothly and continuously, reducing the damages caused by the peak interference.

The present application further discloses a laser ink line device with the laser control circuit as above-mentioned, since the method for connecting the control circuit and an external circuit does not change, the control circuit may be provided in the laser ink line device by the connecting method which is same as that in the prior art, so that the working current would be more smoothly and continuously, and the laser effects would be more variously.

The present application further discloses a control method of the above laser tube. Firstly, classifying all laser tubes into a first laser tube group and a second laser tube group so as to satisfy with the requirements of presenting various effects; Secondly, providing with a control unit corresponding to the first and second laser tube group so as to send a first and second control signal to the first and second laser tube group respectively. According to the different control signals, the control unit completes the alternately startup/shutdown of the first and second laser group.

Wherein, as applied in the above preferred embodiments, the control unit includes a logical control unit, preferred is a AND gate, classifying the control signals into original control signals and inverted control signals, the first control signals are the main control signals and the second control signals are the inverted main control signals.

In the above technical solution, the startup/shutdown state of the first and second laser tube group may be alternately, and the working current is controlled above the maximum working current of the laser tube group instead of the superposition in the prior art, so as to reduce the working current, avoid the interference from peak and prevent the laser tubes from being damaged. Additionally, a continuously and smoothly current is provided when the laser ink line device works, which may extend discharge time of Alkaline dry battery and NI-MH battery.

## Claims

1. A laser control circuit, comprising at least two laser diodes (LD1, LD2) and a control unit controlling the at least two laser diodes respectively, wherein the control unit sends control signals to the at least two laser diodes to control startup/shutdown thereof, wherein the control unit comprises:
a main pulse signal generator (1) and a logic control unit, wherein
the main pulse signal generator, the logic control unit and the at least two laser diodes are connected successively;
the main pulse signal generator sends control signals to the logic control unit; and
the logic control unit classifies the control signals into different types of control signals and sends to the at least two laser diodes, causing the at least two laser diodes to present different working conditions, wherein
the logic control unit comprises a NOT gate;
the at least two laser diodes include a first laser diode group (LD1) and a second laser diode group (LD2);
an output end of the main pulse signal generator is connected with an input end of the NOT gate and the first laser diode group so as to send a main control signal to the input end of the NOT gate and the first laser diode group;
an output end of the NOT gate connected with the second laser diode group is configured for having the main control signal be inverted and having the first and second laser group startup/shutdown alternately; and
the control unit further comprises:
a first secondary pulse signal generator;
a second secondary pulse signal generator (2);
a first AND gate;
a second AND gate, wherein
the first secondary pulse signal generator is connected with a first input end of the first AND gate and sends a secondary pulse signal to the first AND gate,
the second secondary pulse signal generator is connected with a first input end of the second AND gate and sends a secondary pulse signal to the second AND gate,
a second input end of the first AND gate is connected with the main pulse signal generator, while an output end of the first AND gate is connected with each laser diode of the fist laser diode group; and
a second input end of the second AND gate is connected with the output end of the NOT gate so that the main pulse signal generator and the secondary pulse signal generators control the startup/shutdown of each laser diode, while an output end of the second AND gate is connected with each laser diode of the second laser diode group.

2. The laser control circuit according to claim 1, **characterized in that**, the main pulse signal generator and the secondary pulse signal generator are a Single Chip Microcomputer.

3. The laser control circuit according to claim 1, **characterized in that**, the main control signal and the secondary control signal have a frequency of 10kHz.

4. The laser control circuit according to any one of claims 1 to 3, **characterized in that**, the first and second laser diode group include one laser diode respectively.

5. A laser ink line device with the laser control circuit of claim 1.

## Patentansprüche

1. Lasersteuerschaltung, umfassend mindestens zwei Laserdioden (LD1, LD2) und eine Steuereinheit, die jeweils die mindestens zwei Laserdioden steuert, wobei die Steuereinheit Steuersignale an die mindestens zwei Laserdioden sendet, um deren Start/Abschaltung zu steuern, wobei die Steuereinheit umfasst:
einen Hauptpulssignalgenerator (1) und eine Logiksteuereinheit, wobei
der Hauptpulssignalgenerator, die Logiksteuereinheit und die mindestens zwei Laserdioden hintereinander geschaltet sind;
der Hauptpulssignalgenerator Steuersignale an die Logiksteuereinheit sendet; und
die Logiksteuereinheit die Steuersignale in verschiedene Arten von Steuersignalen klassifiziert und an die mindestens zwei Laserdioden sendet, wodurch die mindestens zwei Laserdioden unterschiedliche Arbeitsbedingungen aufweisen, wobei
die Logiksteuereinheit ein NOT-Gatter umfasst;
die mindestens zwei Laserdioden eine erste Laserdiodengruppe (LD1) und eine zweite Laserdiodengruppe (LD2) umfassen;
ein Ausgabeende des Hauptpulssignalgenerators mit einem Eingabeende des NOT-Gatters und der ersten Laserdiodengruppe verbunden ist, um ein Hauptsteuersignal an das Eingabeende des NOT-Gatters und der ersten Laserdiodengruppe zu senden;
ein Ausgabeende des NOT-Gatters, das mit der zweiten Laserdiodengruppe verbunden ist, dazu ausgelegt ist, dass das Hauptsteuersignal invertiert wird und die erste und zweite Lasergruppe abwechselnd starten/abschalten; und
die Steuereinheit ferner umfasst:
einen ersten Sekundärpulssignalgenerator;
einen zweiten Sekundärpulssignalgenerator (2);
ein erstes AND-Gatter;
ein zweites AND-Gatter, wobei
der erste Sekundärpulssignalgenerator mit einem ersten Eingabeende des ersten AND-Gatters verbunden ist und ein Sekundärpulssignal an das erste AND-Gatter sendet,
der zweite Sekundärpulssignalgenerator mit einem ersten Eingabeende des zweiten AND-Gatters verbunden ist und ein Sekundärpulssignal an das zweite AND-Gatter sendet,
ein zweites Eingabeende des ersten AND-Gatters mit dem Hauptpulssignalgenerator verbunden ist, während ein Ausgabeende des ersten AND-Gatters mit jeder Laserdiode der ersten Laserdiodengruppe verbunden ist; und
ein zweites Eingabeende des zweiten AND-Gatters mit dem Ausgabeende des NOT-Gatters verbunden ist, so dass der Hauptpulssignalgenerator und der Sekundärpulssignalgenerator den Start/die Abschaltung jeder Laserdiode steuern, während ein Ausgabeende des zweiten AND-Gatters mit jeder Laserdiode der zweiten Laserdiodengruppe verbunden ist.

2. Lasersteuerschaltung nach Anspruch 1, **dadurch gekennzeichnet, dass** der Hauptpulssignalgenerator und der Sekundärpulssignalgenerator ein Einchip-Mikrocomputer sind.

3. Lasersteuerschaltung nach Anspruch 1, **dadurch gekennzeichnet, dass** das Hauptsteuersignal und das Sekundärsteuersignal eine Frequenz von 10kHz haben.

4. Lasersteuerschaltung nach einem der Ansprüche 1 bis 3, **dadurch gekennzeichnet, dass** die erste und zweite Laserdiodengruppe jeweils eine Laserdiode enthalten.

5. Lasertintenlinienvorrichtung mit der Lasersteuerschaltung nach Anspruch 1.

## Revendications

1. Circuit de commande de laser, comprenant au moins deux diodes laser (LD1, LD2) et une unité de commande commandant les au moins deux diodes respectivement, dans lequel l'unité de commande envoie des signaux de commande au moins aux deux diodes laser afin de commander leur démarrage/arrêt, dans lequel l'unité de commande comprend :
un générateur de signal à impulsions principal (1) et une unité de commande logique, dans lequel le générateur de signal à impulsions principal, l'unité de commande logique et les au moins deux diodes laser sont reliés de manière successive ;
le générateur de signal à impulsions principal envoie des signaux de commande à l'unité de commande logique ; et
une unité de commande logique classifie les signaux de commande en différents types de signaux de commande et les envoie au moins aux deux diodes laser, amenant les au moins deux diodes laser à présenter différentes conditions de travail, dans lequel
l'unité de commande logique comprend une porte NON ;
les au moins deux diodes laser comprennent un premier groupe de diodes laser (LD1) et un second groupe de diodes laser (LD2) ;
une extrémité de sortie du générateur de signal à impulsions principal est reliée à une extrémité d'entrée de la porte NON et au premier groupe de diodes laser de façon à envoyer un signal de commande principale à l'extrémité d'entrée de la porte NON et au premier groupe de diodes laser ;
une extrémité de sortie de la porte NON reliée au second groupe de diodes laser est conçue pour que le signal de commande principale soit inversé et pour le démarrage/l'arrêt du premier et du second groupe de diodes laser de manière alternative ; et
l'unité de commande comprend en outre :
un premier générateur de signal à impulsions secondaire ;
un second générateur de signal à impulsions secondaire (2) ;
une première porte ET ;
une seconde porte ET, dans lequel
le premier générateur de signal à impulsions secondaire est relié à une première extrémité d'entrée de la première porte ET et envoie un signal à impulsions secondaire à la première porte ET,
le second générateur de signal à impulsions secondaire est relié à une première extrémité d'entrée de la seconde porte ET et envoie un signal à impulsions secondaire à la seconde porte ET,
une seconde extrémité d'entrée de la première porte ET est reliée au générateur de signal à impulsions principal, tandis qu'une extrémité de sortie de la première porte ET est reliée à chaque diode laser du premier groupe de diodes laser ; et
une seconde extrémité d'entrée de la seconde porte ET est reliée à l'extrémité de sortie de la porte NON de sorte que le générateur de signal à impulsions principal et les générateurs de signal à impulsions secondaire commandent le démarrage/l'arrêt de chaque diode laser, tandis qu'une extrémité de sortie de la seconde porte ET est reliée à chaque diode laser du second groupe de diodes laser.

2. Circuit de commande de laser selon la revendication 1, **caractérisé en ce que**, générateur de signal à impulsions principal et les générateurs de signal à impulsions secondaire sont un micro-ordinateur monopuce.

3. Circuit de commande de laser selon la revendication 1, **caractérisé en ce que**, le signal de commande principale et le signal de commande secondaire ont une fréquence de 10 kHz.

4. Circuit de commande de laser selon l'une quelconque des revendications 1 à 3, **caractérisé en ce que**, le premier et le second groupe de diodes laser comprennent une diode laser respectivement.

5. Dispositif de ligne d'encre de laser comportant le circuit de commande de laser selon la revendication 1.
